# EUROPEAN PATENT SPECIFICATION

(11) **EP 0 464 580 B1**
(45) Date of publication and mention of the grant of the patent: **26.03.1997**
(21) Application number: 91110428.9
(22) Date of filing: 25.06.1991
(51) Int. Cl.: H01L 27/108

(54) **Dynamic random access memory cell with trench type storage capacitor**
Dynamische Speichervorrichtung mit wahlfreiem Zugriff mit Speicherkondensator vom Graben-Typ
Mémoire dynamique à accès aléatoire comprenant un condensateur de stockage sillonné

(30) Priority: 28.06.1990 JP 172310/90
(43) Date of publication of application: 08.01.1992
(73) Proprietor: NEC Corporation, Minato-ku, Tokyo 108-01 (JP)
(72) Inventor: Ishizaka, Masashige, c/o NEC Corporation, Minato-ku, Tokyo (JP)
(74) Representative: Glawe, Delfs, Moll & Partner

(56) References cited:
- DE-A- 3 844 388
- PATENT ABSTRACTS OF JAPAN, vol. 14, no. 70 (E-886)[4013], 8th February 1990; & JP-A-1 287 956
- PATENT ABSTRACTS OF JAPAN, vol. 14, no. 292 (E-944)[4235], 25th June 1990; & JP-A-2 094 562
- PATENT ABSTRACTS OF JAPAN, vol. 13, no. 78 (E-718)[3426], 22nd February 1989; & JP-A-63 260 164

## Description

### FIELD OF THE INVENTION

This invention relates to a dynamic random access memory device and, more particularly, to a storage capacitor forming a part of a memory cell of the dynamic random access memory device.

### DESCRIPTION OF THE RELATED ART

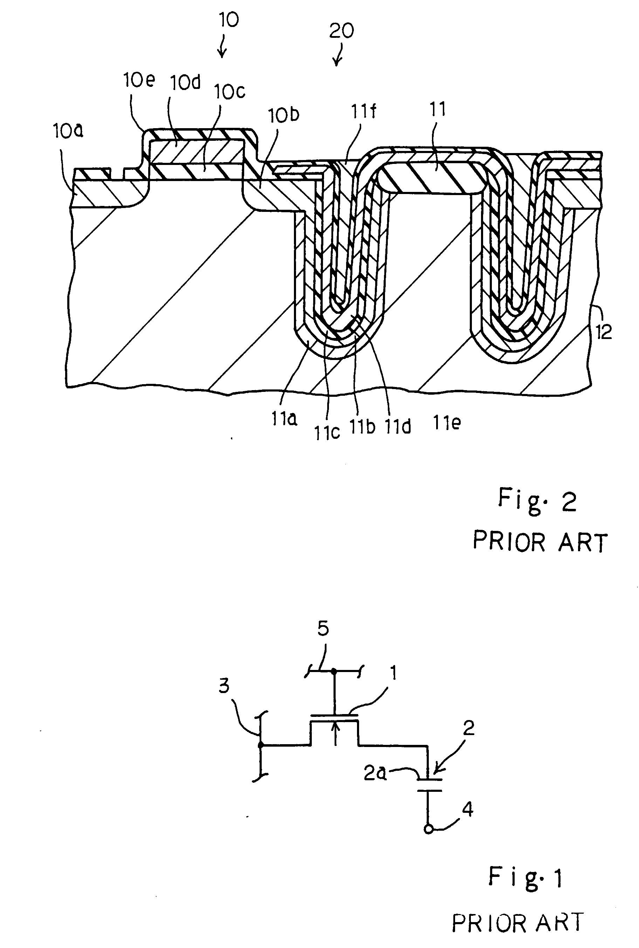

A typical example of the memory cell of a dynamic random access memory device is known as a single-transistor single-capacitor type which is shown in Fig. 1. The single-transistor single-capacitor type random access memory cell is implemented by a series combination of an n-channel type field effect transistor 1 and a storage capacitor 2, and is coupled between a bit line 3 and a reference voltage node 4. The gate electrode of the n-channel type field effect transistor 1 is coupled to a word line 5, and the n-channel type field effect transistor 1 provides a conductive channel between the bit line 3 and the storage capacitor 2 in the presence of a positive high voltage on the word line 5. A data bit is written from the bit line 3 to the storage capacitor 2 in the form of electric charges, and the electric charges indicative of the data bit produces a small difference in voltage level between the bit line 3 and another bit line (not shown) paired therewith in a read-out operation.

If the accumulation electrode 2a of the storage capacitor 2 laterally extends along the major surface of a silicon substrate, the storage capacitor 2 occupies a large amount of real estate of the silicon substrate, and such a planar type storage capacitor is not desirable in view of high integration density. For this reason, a trench type storage capacitor was proposed, and Fig. 2 shows a prior art random access memory cell with a trench capacitor.

A random access memory cell according to the preamble part of the claim is known from patent abstracts of Japan, Vol. 14, No. 70; and JP-A-12 87 956.

DE-A-38 44 388 shows a random access memory device of a partly similar kind.

A further random access memory device is shown in patent abstracts of Japan, Vol. 13, No. 78; and JP-A-63 260 164. In this device the cell is formed onto the whole circumference of a trench in a self alignment manner.

In Fig. 2, reference numerals 10 and 20 respectively designate a switching transistor and a storage capacitor coupled in series. A thick field oxide film 11 is selectively grown on the major surface so that active areas are defined in the major surface of a silicon substrate 12, and the switching transistor 10 and the storage capacitor 20 are formed in one of the active areas. Two n-type impurity regions 10a and 10b are formed beneath the major surface in spacing relation, and a thin gate oxide film 10c is grown on that area between the n-type impurity regions 10a and 10b. A gate electrode 10d is formed on the thin gate oxide film 10c, and is covered with an insulating film 10e. A trench projects into the silicon substrate 12, and is defined by a wall portion 11a doped with p-type impurity atoms. The p-type wall portion 11a is so heavily doped that a depletion layer can not widely extend, and, for this reason, capacitance between the p-type wall portion 11a and the n-type accumulation electrode 11b is increased. An n-type accumulation electrode 11b is held in contact with the p-type wall portion 11a, and is contiguous to the n-type impurity region 10b. A dielectric film 11c covers the n-type accumulation electrode 11b, and defines a secondary trench. On the dielectric film 11c is provided an n-type counter electrode 11d which is shared between a plurality of memory cells adjacent to one another. The counter electrode 11d is covered with an insulating film 11e, and a tertiary trench defined by the dielectric film 11e is filled with polysilicon 11f. The gate electrode 10d forms a part of the associated word line, and the n-type impurity region 10a is electrically connected to a bit line.

It is desirable for the trench type capacitor 20 to be as close to the thick field oxide film 11 as possible in view of reduction of occupation area, and, for this reason, the p-type wall portion 11a and the n-type accumulation electrode 11b are substantially aligned with the peripheral edge of the thick field oxide film 11. However, a problem is encountered in the prior art random access memory cell in that a large amount of leakage current takes place across the n-type accumulation electrode 11b and the p-type wall portion 11a. This is because of the fact that thermal stress due to difference in thermal expansion coefficient between silicon and silicon oxide concentrates around the peripheral edge of the thick field oxide film 11. As described hereinbefore, the junction between the p-type wall portion 11a and the n-type accumulation electrode 11b is located beneath the peripheral edge of the thick field oxide film 11, and, for this reason, the concentration of stress produces distortion in the crystal structures of the p-type wall portion 11a as well as the n-type accumulation electrode 11b where the depletion layer occupies. The distortion tends to provide current path between the p-type wall portion 11a and the n-type accumulation electrode 11b, and electric charges indicative of a data bit are liable to flow through the current path.

### SUMMARY OF THE INVENTION

It is therefore an important object of the present invention to provide a random access memory cell a trench type storage capacitor of which is less influenceable by the thermal stress.

This object is solved by the features of the claim.

### BRIEF DESCRIPTION OF THE DRAWINGS

The features and advantages of the random access memory device according to the present invention will be more clearly understood from the following description taken in conjunction with the accompanying drawings in which:
Fig. 1 is a diagram showing the equivalent circuit of a prior art random access memory cell;
Fig. 2 is a cross sectional view showing the structure of the prior art random access memory cell;
Fig. 3 is a cross sectional view showing the structure of a further random access memory cell ; and
Fig. 4 is a cross sectional view showing the structure of a random access memory cell according to the present invention.

### DESCRIPTION OF THE PREFERRED EMBODIMENT

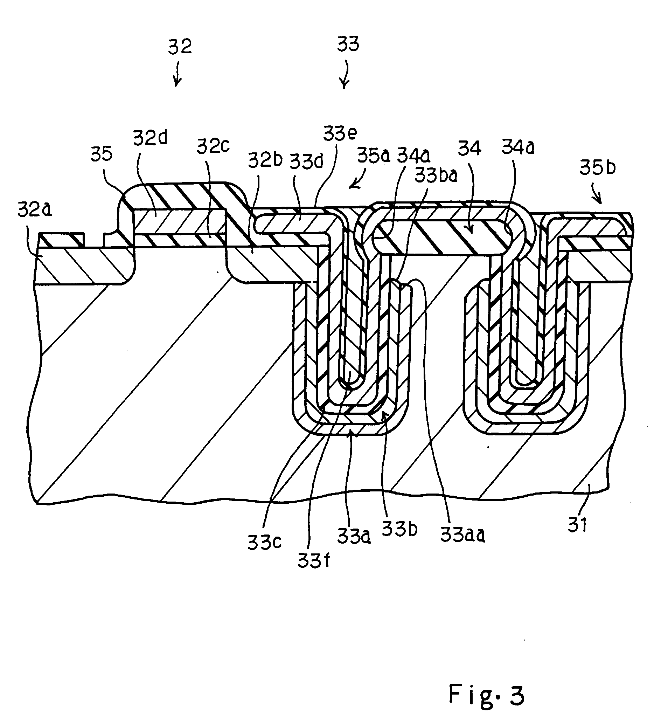

Referring to Fig. 3 of the drawings, a random access memory cell is fabricated on a lightly doped single crystal silicon substrate 31, and the random access memory cell largely comprises a switching transistor 32 coupled to a bit line (not shown) and a storage capacitor 33 electrically coupled to the switching transistor 32. A thick field oxide film 34 of silicon dioxide is grown on the major surface of the silicon substrate 31, and a plurality of active areas 35a and 35b are isolated from one another by the thick field oxide film 34. In other words, peripheral edge 34a of the thick field oxide film 34 defines the active areas 35a and 35b in the major surface.

The switching transistor 32 comprises heavily doped n-type impurity regions 32a and 32b spaced apart from each other, a thin gate oxide film 32c grown on that area between the heavily doped n-type impurity regions 32a and 32b, and a gate electrode 32d formed on the gate oxide film 32c. The heavily doped impurity regions 32a and 32b serves as source and drain regions of the switching transistor, and the gate electrode 32d forms a part of a word line. Though not shown in Fig. 3, the heavily doped n-type impurity region 32a is coupled to the bit line. The gate electrode 32d is covered with a silicon oxide film 35.

A trench is formed in the silicon substrate 31, and a wall portion 33a defining the trench is heavily doped with p-type impurity atoms. Since the trench is partially located under the thick field oxide film 34, an upper peripheral edge 33aa of the wall portion 33a is located under the thick field oxide film 34, and is spaced apart from the peripheral edge 34 of the thick field oxide film 34. The wall portion 33a defines a secondary trench, and a heavily doped n-type accumulation electrode 33b extends along the secondary trench for forming a p-n junction therebetween. Since the secondary trench is still partially located under the thick field oxide film 34, an upper peripheral edge 33ba is also partially under the thick field oxide film 34, and is spaced apart from the peripheral edge 34a of the thick field oxide film 34. The heavily doped n-type accumulation electrode 33b is held in contact with the heavily doped n-type impurity region 32b so that a data bit in the form of electric charges reaches the accumulation electrode 33b.

The heavily doped n-type accumulation electrode 33b is covered with a dielectric film 33c which defines a tertiary trench. A counter electrode 33d extends along the tertiary trench as well as over the thick field oxide film 34, and is shared between storage capacitors including the storage capacitor 33. The dielectric film 33c has an upper peripheral edge merged with the silicon oxide film 35 and the thick field oxide film 34 so that the counter electrode 33d is perfectly isolated from the accumulating electrode 33b. In this instance, the dielectric film is formed of silicon oxide, however, a composite dielectric film structure may be used for the storage capacitor 33. Such a composite dielectric film structure may be implemented by a silicon nitride film sandwiched between two silicon oxide films. The counter electrode 33d is covered with a dielectric film 33e, and a gap defined by the dielectric film 33e is filled with a polysilicon block 33f.

In this instance, the heavily doped n-type accumulation electrode 33b is doped at about 10¹⁸ cm⁻³, and the p-n junction between the heavily doped p-type wall portion 33a and the heavily doped n-type accumulation electrode 33b is negatively biased at about 8 volts. A depletion layer extends from the p-n junction into the heavily doped p-type wall portion 33a and the heavily doped n-type accumulation electrode 33b, and measures about 0.1 micron from the p-n junction into the heavily doped n-type accumulation electrode 33b. Therefore, the p-n junction is laterally spaced apart from the peripheral edge 34a by at least 0.1 micron so that the depletion layer is hardly affected by concentration of stress due to difference in thermal expansion coefficient between silicon and silicon dioxide.

In operation, when a data bit is written into the random access memory cell, the gate electrode 32d is applied with a positive high voltage level, and a conductive channel takes place between the heavily doped n-type impurity regions 32a and 32b, and the data bit passes through the switching transistor. The data bit reaches the accumulation electrode 33b, and is stored in the form of electric charges. Since any crystal defect due to the concentration of stress is less liable to take place in the depletion layer, the electric charges accumulated in the accumulation layer 33b are hardly discharged to the silicon substrate, and the data bit is maintained for a prolonged time period. The data bit is read out form the storage capacitor 33 upon application of the positive high voltage level to the gate electrode 32d.

### Embodiment

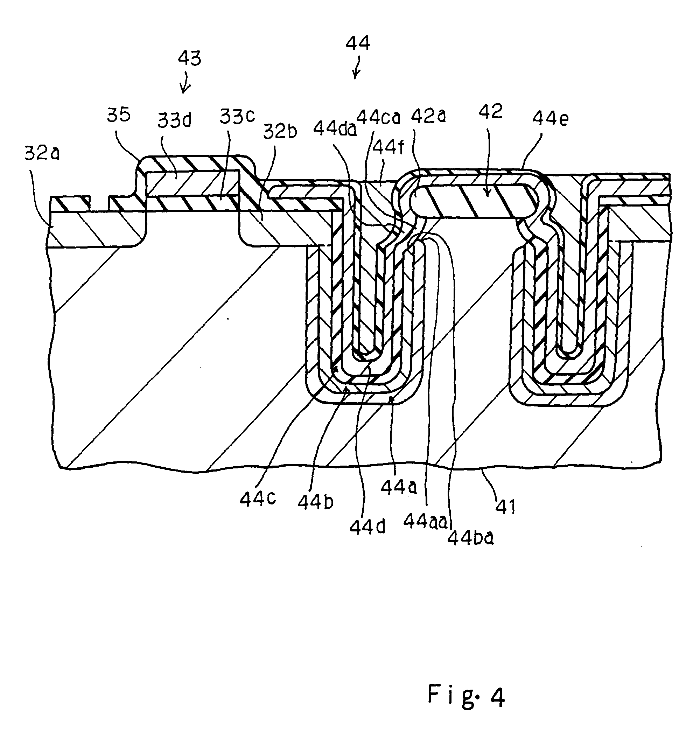

Turning to Fig. 4, a random access memory cell according to the invention is fabricated on a lightly doped single crystal silicon substrate 41, and a thick field oxide film 42 is selectively grown on the major surface of the silicon substrate 41 so that a peripheral edge 42a defines active areas where memory cells as well as peripheral circuits are formed. The random access memory cell largely comprises a switching transistor 43 and a storage capacitor 44, and the switching transistor 43 is similar to the switching transistor 32. For this reason, component regions and films are designated by the same references used in Fig. 3. The storage capacitor 44 is formed in the active areas together with the switching transistor 43, however, a part of the storage capacitor 44 is located under the thick field oxide film 42 as similar to the storage capacitor 33.

A heavily doped wall portion 44a and a heavily doped n-type accumulation electrode 44b correspond to those of Fig. 3, and no further description is incorporated hereinbelow. One of differences from Fig. 3 is a generally funnel-shaped dielectric film structure 44c, and the upper portion 44ca of the generally funnel-shaped dielectric film structure 44c is terminated at a bottom surface of the thick field oxide film 42 spaced apart from the peripheral edge 42a. A counter electrode 44d traces the generally funnel-shaped dielectric film structure 44c, and has, accordingly, a portion 44da laterally departing wider away from the lower portion of the counter electrode 44d. The counter electrode 44d is covered with a dielectric film 44e, and a gap defined by the dielectric film 44e is filled with polysilicon 44f.

The dielectric film structure 44c and, accordingly, the counter electrode 44d are deformed in such a manner as to terminated at the bottom surface of the thick field oxide film 42 spaced apart from the peripheral edge 42a, and this configuration partially takes up a thermal stress due to difference in thermal expansion coefficient between silicon and silicon dioxide. Therefore, distortion due to the thermal stress is smaller than that in RAM-cell of Fig. 3, and a depletion layer is less liable to suffer from crystal defect by virtue of the location of the p-n junction between the heavily doped p-type wall portion 44a and the heavily doped n-type accumulation electrode 44b.

As will be understood from the foregoing description, the random access memory cell according to the present invention does not suffer from a large amount of leakage current due to the crystal defect in the depletion layer. This advantage is resulted from the location of the p-n junction spaced apart from the peripheral edge of the thick field oxide film.

## Claims

1. A random access memory cell fabricated on a lightly doped semiconductor substrate (41) of a first conductivity type, comprising:
a) a switching transistor (43) formed in an active area of a major surface of said lightly doped semiconductor substrate defined by a peripheral edge (42a) of a field oxide film (42) grown on the major surface; and
b) a storage capacitor (44) connected to said switching transistor, and comprising
b-1) a heavily doped wall portion (44a) of said first conductivity type defining a trench in said lightly doped semiconductor substrate, and having an upper peripheral edge (44aa) partially located under said field oxide film and spaced apart from said peripheral edge (42a) of said field oxide film,
b-2) an accumulating electrode (44b) having a second conductivity type opposite to said first conductivity type, and held in contact with said heavily doped wall portion forming a p-n junction therebetween, said accumulating electrode defining a secondary trench, said accumulating electrode having an upper peripheral edge (44ba) partially located under said field oxide film and spaced apart from said peripheral edge (42a) of said field oxide film, said accumulating electrode being electrically connected to said switching transistor, a depletion layer extending over a predetermined distance from said p-n junction into said accumulating electrode, a lateral distance between said peripheral edge (42a) of said field oxide film and said p-n junction being equal to or greater than said predetermined distance.
b-3) a dielectric film structure (44c) extending along said secondary trench covering said accumulating electrode (44b), and defining a tertiary trench, and
b-4) a counter electrode (44d) extending along said tertiary trench and held in contact with said dielectric film structure
**characterized in** that
said dielectric film structure (44c) has an upper portion (44ca) terminated at a bottom surface of said field oxide film (42) spaced apart form said peripheral edge (42a) of said field oxide film by a predeterminded distance wider than that between the peripheral edge (42a) of said field oxide film and said upper peripheral edge (44aa) of said heavily doped wall portion (44a), said counter electrode also having a portion (44da) tracing said upper portion of said dielectric film structure terminated at the bottom surface of said field oxide film.

## Patentansprüche

1. Speichervorrichtung mit wahlfreiem Zugriff, die auf einem schwach dotierten Halbleitersubstrat (41) von einem ersten Leitfähigkeitstyp hergestellt ist, mit:
a) einem Schalttransistor (43), der in einem aktiven Bereich der Hauptfläche des schwach dotierten Halbleitersubstrats geformt ist, definiert durch eine Umfangskante (42a) eines Feldoxidfilms (42), der auf die Hauptfläche aufgewachsen ist; und
b) einem Speicherkondensator (44), der an den Schalttransistor angeschlossen ist, und aufweist:
b-1) einen stark dotierten Wandteil (44a) vom ersten Leitertyp, der einen Graben im schwach dotierten Halbleitersubstrat definiert, und eine obere Umfangskante (44aa) aufweist, die teilweise unter dem Feldoxidfilm liegt und zu der Umfangskante (42a) des Feldoxidfilms einen Abstand aufweist;
b-2) einer akkumulierenden Elektrode (44b), von einem zweiten Leitfähigkeitstyp, entgegengesetzt zum besagten ersten Leitfähigkeitstyp hat, die mit dem stark dotierten Wandteil in Kontakt gehalten wird, wobei dazwischen ein p-n-Übergang gebildet ist, wobei die akkumulierende Elektrode einen zweiten Graben definiert, die akkumulierende Elektrode eine obere Umfangskante (44a) hat, die teilweise unter dem Feldoxidfilm liegt und zur Umfangskante (42a) des Feldoxidfilms einen Abstand hat, wobei die akkumulierende Elektrode elektrisch an den Schalttransistor angeschlossen ist, wobei sich über einen vorbestimmten Abstand vom p-n-Übergang in die akkumulierende Elektrode hinein eine Sperrschicht erstreckt, und wobei ein seitlicher Abstand zwischen der Umfangskante (42a) des Feldoxidfilms und dem p-n-Übergang gleich oder größer als der vorbestimmte Abstand ist;
b-3) einer dielektrischen Filmstruktur (44c), die sich entlang dem zweiten Graben erstreckt, die akkumulierende Elektrode (44b) abdeckt, und einen dritten Graben definiert, und
b-4) einer Zählerelektrode (44d), die sich entlang dem dritten Graben erstreckt, und mit der die elektrische Filmstruktur in Kontakt gehalten ist,
dadurch **gekennzeichnet,** daß die dielektrische Filmstruktur (44c) einen oberen Teil (44ca) hat, der an einer Bodenfläche des ersten Feldoxidfilms (42) mit einem vorbestimmten Abstand zur Umfangskante (42a) endet, der breiter als der Abstand zwischen der Umfangskante (42a) des Feldoxidfilms und der oberen Umfangskante (44aa) des stark dotierten Wandteils (44a) ist, wobei die Zählerelektrode auch einen Teil (44da) hat, der dem oberen Teil der dielektrischen Filmstruktur folgt, der an der Bodenfläche des Feldoxidfilms endet.

## Revendications

1. Cellule de mémoire à accès aléatoire fabriquée sur un substrat de semi-conducteur faiblement dopé (41) d'un premier type de conductivité, comprenant :
a) un transistor de commutation (43) formé dans une surface active d'une surface principale dudit substrat de semi-conducteur faiblement dopé définie par une partie périphérique (42a) d'une couche d'oxyde de champ (42) tirée sur la surface principale ; et
b) un condensateur de mémorisation (44) connecté audit transistor de commutation, et comprenant :
b-1) une partie de paroi fortement dopée (44a) dudit premier type de conductivité définissant un sillon dans ledit substrat de semi-conducteur légèrement dopé, et ayant une partie périphérique supérieure (44aa) en partie située sous ladite couche d'oxyde de champ et espacée de ladite partie périphérique (42a) de ladite couche d'oxyde de champ,
b-2) une électrode d'accumulation (44b) ayant un second type de conductivité opposé audit premier type de conductivité, et maintenue en contact avec ladite partie de paroi fortement dopée formant une jonction p-n entre elles, ladite électrode d'accumulation définissant un sillon secondaire, ladite électrode d'accumulation ayant une partie périphérique supérieure (44ba) en partie située sous ladite couche d'oxyde de champ et espacée de ladite partie périphérique (42a) de ladite couche d'oxyde de champ, ladite électrode d'accumulation étant connectée électriquement audit transistor de commutation, une zone de déplétion s'étendant au-dessus d'une distance prédéterminée de ladite jonction p-n dans ladite électrode d'accumulation, une distance latérale entre ladite partie périphérique (42a) de ladite couche d'oxyde de champ et ladite jonction p-n étant égale ou supérieure à ladite distance prédéterminée.
b-3) une structure de couche diélectrique (44c) s'étendant le long dudit sillon secondaire couvrant ladite électrode d'accumulation (44b), et définissant un sillon tertiaire, et
b-4) une électrode de dispositif de comptage (44d) s'étendant le long dudit sillon tertiaire et maintenue en contact avec ladite structure de couche diélectrique
caractérisé en ce que
ladite structure de couche diélectrique (44c) a une partie supérieure (44ca) achevée sur la surface du bas de ladite couche d'oxyde de champ (42) espacée de ladite partie périphérique (42a) de ladite couche d'oxyde de champ d'une distance prédéterminée, supérieure à celle entre la partie périphérique (42a) de ladite couche d'oxyde de champ et ladite partie périphérique supérieure (44aa) de ladite partie de paroi fortement dopée (44a), ladite électrode de dispositif de comptage ayant également une partie (44da) qui suit ladite partie supérieure de ladite structure de couche diélectrique achevée sur la surface du bas de ladite couche d'oxyde de champ.
